# EUROPEAN PATENT APPLICATION

(11) **EP 1 446 001 A2**
(43) Date of publication of application: **11.08.2004**
(21) Application number: 04250618.8
(22) Date of filing: 05.02.2004
(51) Int. Cl.: H05K 13/08

(54) **Manufacturing circuit boards**

(30) Priority: 05.02.2003 GB 0302635
(71) Applicant: Omron Europe B.V., 2132 JD Hoofddorp (NL)
(72) Inventor: Yoshiki, Fujii, Omron Institute of Life Science Co, Kyoto, 615-0084 (JP); Hiroshi, Yamazaki, Staples Corner, London NW2 7HF (GB); Gardner, Colin, Staples Corner, London NW2 7HF (GB)
(74) Representative: Calderbank, Thomas Roger

(57) **Abstract**

In order to investigate whether a plurality of identical components (1215, 1217) on one or more circuit boards (1205, 1207) are correct, or not, the characters (200) on the components are read (1205, 1207) by optical character recognition (201) and compared (203) with data (202) representing the characters that should be read if the components are correct (1205, 1207). In the present invention, the system operates by determining that all the components (1205, 1207) are correct, if a sufficiently high number of them are correct, or a sufficiently low number of them are determined to be incorrect. Since the components are identical, it is usually possible to read the characters (200) on only some of the components to determine if all are correct or not.

## Description

The present invention relates to the manufacture of circuit boards, and in particular is concerned with determining whether components have been correctly mounted on one or more circuit boards.

When an electrical circuit is manufactured, a large number of components have to be mounted on a circuit board which interconnects those components in the way desired in order to cause those components to interact, and thus for the circuit formed on the circuit board to operate correctly. In most cases, the manufacture of such circuit boards occurs in an automated process, with the components being mounted by an appropriate placement and soldering system. In such an arrangement, a circuit board has appropriate tracks formed thereon, to define electric connections of the resulting circuit, and then solder is applied at appropriate locations on the circuit board. The components are then mounted on the board, and the resulting structure heated to cause the solder to melt and to flow over the components. Then, the solder is allowed to solidify, so that the components are firmly mounted on the board.

In an automated operation of manufacture, it is usual for a plurality of identical components to be mounted on or in common mounting structure, to enable the mounting apparatus to lift a component from that structure and transport it to the board for mounting thereon. That mounting structure may, for example, be a reel of tape to which the components are contained, or a tube containing a plurality of components. In many cases, a circuit board will have a plurality of identical components, which will then all be lifted from the common mounting structure. In other situations, identical components from the same mounting structure will be used on a plurality of boards.

Such manufacturing techniques are subject to errors in mounting the components. There are three primary types of errors. The first is that the wrong component has been mounted on the board. This can occur, for example, by the use of the wrong mounting structure carrying the mounting components during the manufacturing process or because the mounting arrangement was programmed to take components from the wrong mounting structure for a particular location on the board. The second type of error is that the components were mounted in a position which was not exactly correct. To address this latter problem, it is common for such circuit board manufacturing arrangements to have an inspection step carried out prior to the heating of the solder. This inspection may be carried out automatically. The third possible error is that the solder does not flow correctly onto the component, so fails to secure it correctly to the board. Again, it is usual to inspect the board after the heating step, and again such inspection may be carried out automatically.

Where the boards are inspected, and found not to be correct, they are then sent to an appropriate repair station.

The present invention is concerned with the problem that the wrong components may be mounted on the board. In practice, electrical components usually have one or more characters printed on their surface to enable them to be identified, and therefore it might be thought that it would be possible to read those characters by suitable optical character recognition (OCR) equipment, compare them with the characters that should be present if the component is correct, and say that the correct component has been mounted if the two are in agreement. However, such character recognition arrangements turn out to be unreliable. The characters are not easy to read by known OCR techniques because they are often printed poorly, and may become smudged or otherwise degraded, and also they have to be read in a situation where the contrast is small. Therefore, the accuracy of such OCR arrangements is much less than is achieved than in reading e.g. printed documents and the result is that the probability of mis-reading comes sufficiently high that too many errors would be detected.

However, the inventors of the present invention have realised that there is a solution to this. As has previously been mentioned, when the mounting apparatus wants to mount a plurality of identical components, it will obtain those components from a common mounting structure. Thus, where there are to be a plurality of the same components on a board, or on a plurality of boards, then either all those components will be correct, or they will all be wrong. Therefore, the fact that the components come from a common mounting structure can be used when considering the results of the OCR investigation.

Therefore, at its most general, the present invention proposes that all (a first predetermined number) of the components are determined to be correct if another predetermined number of them are identified as correct. That identification can then be achieved in two ways, based on sufficiently high percentage of successful readings, or a sufficiently low percentage of unsuccessful readings. In the former case, a second predetermined number of the components have their characters read, and compared with the correct set of characters for the correct component. If a third predetermined number, less than the second, are identified as having their characters matching the correct set for those components, then all the components are determined to be correct, even if there are some OCR readings for which the characters read do not match the correct set of characters. Thus, if there are one hundred identical components on a board, five may be investigated (first predetermined number = 100) (second predetermined number = 5). If four are then identified as being correct (third predetermined number = 4), with the read characters matching the correct character set, then it is determined that all one hundred components are correct. If, on the other hand, fewer than four are identified as being having the correct characters, then there is some doubt as to the correctness of all one hundred components.

As was mentioned above, it is also possible for the invention to operate on the basis of a maximum number of cases where the characters read do not match the correct character set. Thus, in the example above, if the characters of two or more components did not match the correct character set, then it can be determined that all one hundred components may be incorrect.

Thus, according to a first aspect of the present invention, there may be provided a method of manufacturing one or more circuit boards, including inspection of a predetermined number of identical components on said one or more circuit boards, comprising the steps of:
a) mounting a first predetermined number of identical components on said one or more circuit boards;
b) investigating a second predetermined number of said identical components on said one or more circuit boards, said investigation including reading characters on said second predetermined number of said identical components using an optical character reader;
c) for each of said second predetermined number of said identical components, comparing said characters with a stored set of characteristics;
d) determining if at least a third predetermined number of said second predetermined number of said plurality of identical components are such that the characters read therefrom correspond to said stored set of characters, said third predetermined number being less than the second predetermined number.
e) determining that said one or more circuit boards have been manufactured correctly in respect of all said first predetermined number of identical components if the determination at step (d) is achieved.

Also, according to a second aspect of the invention, there may be provided a method of manufacturing one or more circuit boards, including inspection of a predetermined number of identical components on said one or more circuit boards, comprising the steps of:
a) mounting a first predetermined number of identical components on said one or more circuit boards;
b) investigating a second predetermined number of said identical components on said one or more circuit boards, said investigation including reading characters on said second predetermined number of said identical components using an optical character reader;
c) for each of said second predetermined number of said identical components comparing said characters with a stored set of characteristics;
d) determining if no more than a fourth predetermined number said fourth predetermined number being of said second predetermined number of said identical components are such that the characters read therefrom do not correspond to said stored set of characters, said fourth predetermined number being less than the first predetermined number; and
e) determining that said one or more circuit boards have been manufactured correctly in respect of all said first predetermined number of identical components if the determination at step (d) is achieved.

Suppose now that a second predetermined number of components has been read, and the results of the comparison of the characters read therefrom with the stored (correct) character set have produced a success rate that is too low, i.e. that the number of cases where the read characters and the correct set do not correspond is less than the third predetermined number. It would be possible to say that all the components are incorrect and reject the circuit board or boards accordingly. However, since the invention is based on the realisation that characters or components may be read incorrectly, it can be appreciated that there will be occasions when, due to statistical variation, the number of incorrect readings of the characters on the component will vary, and could result in an apparently incorrect determination. This is particularly significant when the number of components which are read, out of the total number of components, is small. Thus, in the example given above, if five components out of one hundred are investigated, for two of them the characters which are read do not match the correct set of characters, then there could be uncertainty as to whether components are correct.

In this situation, the present invention proposes that more of the components are investigated, by reading their characters. If the proportion of times the characters read by the components match the correct character set tends to increase, with increasing number of characters, then it is increasingly likely that all the components are correct. If, on the other hand, the number of times the characters read match the correct set tends to decrease, then it is increasingly likely that all the components are incorrect. Therefore, although at least 50% successful comparisons will normally be needed, in practice it is desirable to achieve at least 75% successful comparisons, where the characters read from the components match the stored set of characters, more preferably at least 85%.

If, on the other hand, the invention operates by detecting failures, then the failure rate should not exceed 25%, more preferably 15%.

In general, the present invention is applied to investigation to identical components on the same board. It can be assumed that all the components come from a common mounting structure. However, it is also possible to apply the invention over a plurality of circuit boards. Thus, if only one component is mounted on a circuit board, the invention may be applied over a plurality of circuit boards, investigating that component on all of the boards. Thus, if one hundred boards have each have a preselected component thereon, the first five boards are investigated, and four of them have the correct component, determined by confirming that the characters read from that component match the correct set of characters for that component, then it can be determined that the correct component has been mounted on each of the hundred boards.

In general, it is desirable that the number of components read will be less than the total number of those components on a board or boards (i.e. the second predetermined number is less than the first predetermined number). However, in some situations where the number of the identical components on the board or boards is small, it may be necessary to read the characters of all the components. Even in that case, the present invention may be applied to prevent a board being detected as faulty, because e.g. there is one component which the characters read does not correspond to the correct set. However, where the number of components is large, it becomes possible to read only some of the components, thereby saving time in the investigation.

As was mentioned earlier, components mounted on circuit boards may be investigated prior to the reflow of the solder, or after. The present invention may be applied in either case, although it is often convenient if it is applied in the latter case, since the investigations of the correct soldering usually involve optical processes, and such optical processes may be combined with the OCR arrangements needed for the present invention.

In the discussion above, we have discussed reading characters from a component. It can be observed that the present invention may be applied when the component carries a single character. The character or characters may be numbers, letters, Chinese or Japanese characters, or any other symbol which enables the component to be identified. Normally, using OCR techniques, the character or characters may be read as a bit map, and either that bit map is either compared directly with a corresponding bit map stored representing the correct character or characters, or the bit map is converted to code representing the character or characters (e.g. ascii code) and then compared with code corresponding to the correct characters.

An embodiment of the present invention will now be described in detail, by way of example, with reference to the accompanying drawings in which:
Fig. 1 illustrates a circuit board assembly system in which the present invention may be used;
Fig. 2 shows an optical scanning system for use in the present invention; and
Fig. 3 shows the comparison operations carried out in an embodiment of the invention.

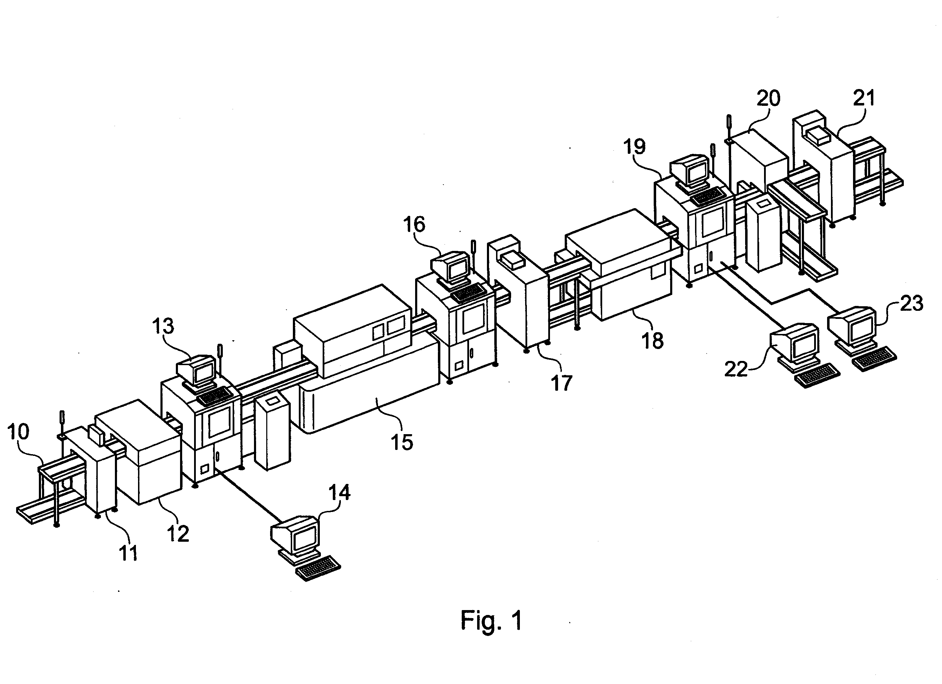

Referring first to Fig 1, the components of a circuit board assembly system in which the present invention may be used as several stages. Circuit boards are mounted on a transport conveyor 10 which extends through the whole of the system of Fig. 1 by a loader. The boards are passed to a printer 12 which prints solder onto the existing tracks of conductive material on the board. Prior to any mounting of components on the boards, the boards are passed to a first inspection unit 13 which inspects the solder paste to ensure it is positioned correctly and is complete. A computer 14 may be associated with the inspection unit 13 to permit the operator to input control factors for determining the accuracy or otherwise of the solder paste printing. The conveyor then passes the boards to a placement machine 15 in which a multiplicity of electronic components are mounted on the board at the desired locations. Although not shown in Fig. 1, the placement machine 15 has a plurality of mounting structures e.g. reels or other devices, each of which holds plurality of identical components. Each time the placement machine places a component on the board, it removes the desired component from the appropriate reel and positions on the board. The placement machine is programmed to take each desired component and position it appropriately on the board. Thus, it can be assumed that if the placement machine is programmed correctly all components intended to be identical on the board will come from the same reel and thus will, in fact, all be identical. As was mentioned previously, it is sometimes the case that the wrong reel has been mounted in the placement machine, resulting the wrong component being mounted on the board.

In the arrangement of Fig. 1, the board with all appropriate components mounted thereon is passed to a second inspection unit 16 in which a check is made to determine whether the components have been positioned in the correct location, and then the boards are passed via a NG Stocker unit 17 to a reflow oven 18. The purpose of a NG Stocker is to separate boards where the components have been positioned correctly from those which they have not. Only the former one passed to the reflow oven 18. The reflow oven 18 heats the boards to cause the solder paste thereon to melt, and the melted solder then flows onto the component. Once the solder cools, when the boards leave the reflow oven 18, the components are then bonded to the board by the solder, and interconnected by the appropriate conductive tracks. The conveyor 10 then moves the board to a third inspection unit 19 in which the soldering of the components to the board is checked. If the checking shows that the components have been soldered correctly, the boards are passed to a further NG Stocker unit 20, which separates the boards which have been soldered correctly from those which have not. Correctly soldered boards are passed to an unloader unit 21 which removes the completed boards from the conveyor 10. As shown in Fig. 1, the inspection unit 19 may be connected to a computer 22 to enable it to be programmed to carry out the appropriate checks on the solder. If the board fails those checks, the board may be passed to a repair station 23 in which a human operator can double-check the solder inspection and repair the board where appropriate.

The present invention may be used in either the second inspection unit 16 or the third inspection unit 19, but the subsequent discussion will concentrate on its use within the third inspection unit 19. Therefore, that inspection unit 19 will be described in more detail.

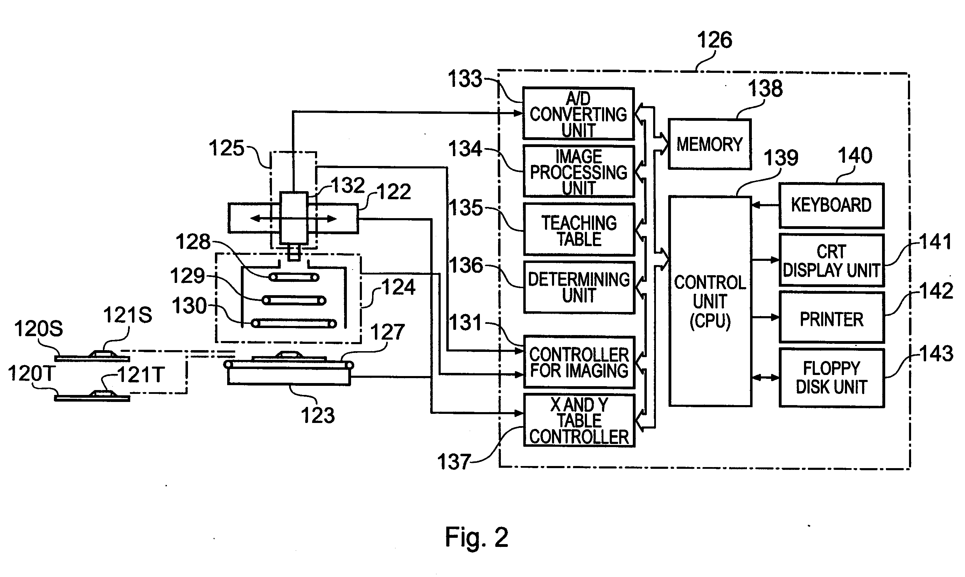

It will be appreciated that, in order to operate correctly, the inspection unit 19 must be pre-programmed to recognise the difference between successfully soldered components and unsuccessfully soldered components. Therefore, in a preliminary step, printed circuit boards which have been pre-checked to ensure that they are correct are inspected by the inspection unit 19, prior to the system of Fig. 1 coming into full operation. Thus, Fig. 2 illustrates a reference PCBs 120, with reference components 121s thereon, and also PCB 120t with components 121t thereon which has not been pre-inspected.

Thus, in the operation of the inspection unit 19, a PCB is placed on a conveyor 127 which is located on a y-axis table 123. In the teaching process, a reference PCB 120s with reference parts 121s is studied to teach the apparatus relevant information such as: size of parts, kind of parts, printed information (labelling parts), location of parts, nature of soldering, and the like. Once this information, the feature parameters, has been extracted and stored, the inspection process can begin and PCBs 120t with parts 121t are placed on the conveyor 127.

As the PCB, whether the PCB 120s with reference parts 121s or the PCB 120t with parts 121t (hereinafter only labelled when discussing the specific PCB, i.e. PCB 120s)moves down the conveyor 127, a light projecting unit 124 projects light onto the PCB. The light projecting unit 124 comprises three ring-shaped light sources: red 128, green 129 and blue 130 having different radii and arranged in positions at different heights from the y-axis 123. Furthermore, the smallest radius is at the greatest height from the y-axis table and, in this embodiment, is green.

When such projected light strikes the surface of the PCB, it is deflected to an imaging unit 125 located directly above the PCB and above and in the centre of the ring-shaped light sources 128, 129, and 130. While the light that strikes rough surfaces such as: integrated circuits, printing, expoxy resin, through holes, copper lands, solder resist, and the like is randomly diffused and, through mixing, becomes white light; incident light striking the smooth surface of the fillets will maintain its specific colour, such coloured incident rays recorded by a camera 132 in an imaging unit 125, indicating the nature of the curved surface.

In the present embodiment, the light sources 129, 128, and 130 respectively have structures in which a white light source is coated with green, red, and blue transparent plates (colour filters). However, the light sources are not limited to those having such structures provided that they produce light of three primary colours. For example, ring shaped fluorescent lamps or neon tubings could also be used.

The incident rays reflected from the PCB are recorded by a colour TV camera 132 which, together with an x-axis table 122 on which the camera 132 is placed, constitutes the imaging unit 125. By moving the PCB down the conveyor 27 in the direction of the y-axis, all of the regions of the PCB are able to be detected. This movement is directed by an x and y table controller 137 which is located in a processing unit 126. The detected images are then converted to electrical signals by the imaging unit 125 and sent to an anolog/digital (A/D) converter 133 which is part of the processing unit 126.

Besides an A/D converter 133 and an x and y table controller 137, the processing unit 126 further comprises:
am image processing unit 134, a teaching table 135, a determining unit 136, a controller for imaging 131, a keyboard 140, a cathode ray tube (CRT) display unit 141, a printer 142, a floppy disk unit 143, a memory 138, and a control unit (CPU) 139.

The AD converter 133 converts the coloured signals of green, red, and blue into digital signals and supplies the same to the random access memory (RAM) 138. The RAM 138 serves as a work area for the CPU 139 and sends the digital signals thereto. Subsequently, the CPU 139 directs the digital signals to the image processing unit 134 which binarizes the aforementioned signals to a colour threshold to distinguish each colour from the other, creating file holding data. The image processing unit 134 performs this function three times, once for each colour. Then, this file holding determining data is returned to the CPU 139 and also distributed to the determining unit 136 or the teaching table 135 if the apparatus is in the teaching mode.

The teaching table 135 stores the file holding determining data when it is supplied from the CPU 139 in the teaching mode. Determining data or feature parameters are for example: width of fillet, end of lead, land location, degree of slope, type of part mounted, direction of mounting, and the like. The teaching table 135 stores the average value of each from the teaching PCBs 120s and 120s with reference parts 121s. There are many feature parameters each further broken down into conditions, in which a majority must be met to satisfy the parameter. In the inspection mode, the teaching table 135 reads out this file holding determining data according to a transfer request to supply the file holding data to the CPU 139 and the determining unit 136.

The determining unit 136 compares the file holding the determining data supplied from the CPU 139 in the inspection mode with the file holding data a be inspected, which was transferred from the image processing unit 134, to determine whether or not a soldered state is good with respect to the PCB 120t with parts 121t to be inspected. Then, the determining unit 136 outputs the results of the determination to the CPU 139.

Also referring to Fig. 2, the image controller 131 and the x and y table controller 137 ensure that the whole PCB is imaged. The image controller 131 comprises, for example, an interface for connecting the CPU 139 with the light projecting unit 124 and the imaging unit 125 and controls, on command from the CPU 139, the amounts of light emitted by the respective light sources 129, 128 and 130; maintaining a balance between light output of hues of the colour television camera 132 to the imaging unit 125.

The x and y table controller comprises, for example, an interface for connecting the CPU 139 to the x-axis table 122 and the y-axis table 123; controlling the tables in response to commands from the CPU 139.

The CRT display unit 141 comprises a cathode-ray tube and displays on its screen image data that is the result of the determinations of feature parameters, keyboard input data, and the like when such data is supplied from the CPU 139. The printer 142 prints out the results of the determination and the like when the same is supplied from the CPU 139. The keyboard 140 comprises various keys required for entering information on operations, data on the reference PCBs 120s and 120s with reference parts 121s, the PCB to be inspected 120t with parts 121t, and the like to be supplied to the CPU 139.

The CPU 139 includes a microprocessor and the like and controls operations in teaching and inspection through the following procedures.

Thus, the apparatus of Fig. 2 derives images of the PCB to enable the accuracy of the soldering operation to be checked. The present invention then makes further use of those images to determine whether the correct components have been mounted on the board.

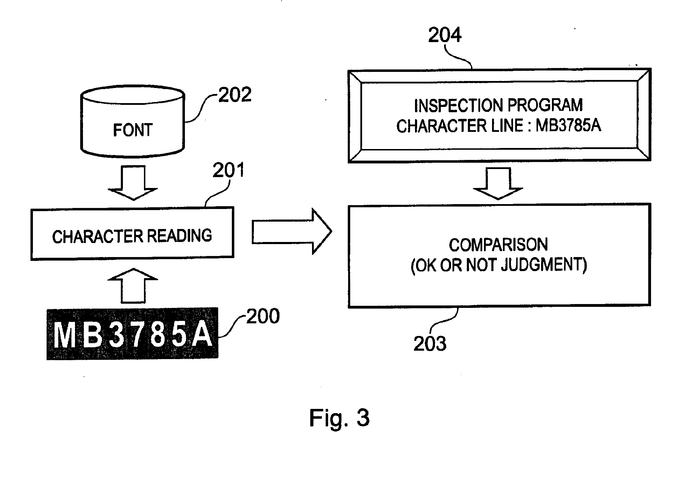

This operation is illustrated schematically in Fig. 3. The first stage is to obtain an image 200 of characters on each component. Virtually all electronic components have at least one, usually several, characters printed thereon to identify them and the present invention seeks to make use of that information to check the correct components have been used in the circuit. To obtain the image 200, the three coloured signals derived from the camera 132 are combined into a single image which thus corresponds to the natural colours of the characters on the component. This combination may occur in the image processing unit 134 of Fig. 2.

The CPU 139, when suitably programmed, may then carry out a character reading operation 201 using e.g. known OCR techniques to attempt to read the characters on each component. The font of the characters may vary from component to component, there may be a font memory 202 (for example, in the memory 138), in which different font information is stored, to enable the character reading operation 201 to use the correct font when attempting to read the characters of the image 200.

The character reading operation 201 then outputs the result of the reading operation and this result may be compared in a comparison operation 203 data corresponding to the characters of the correct component. Those characters are illustrated at 204 in Fig. 3, and the appropriate information for each component may again be stored in the memory 138.

Thus, in principle, the sequence of operations illustrated in Fig. 3 can be used to read the characters on each component, and to determine whether each component is correct or not, by comparison data representing the correct component. Unfortunately, as thus described, this process is not sufficiently accurate to be of practical use. The difficulty arises because the character reading operation 201 is not wholly accurate. As illustrated in Fig. 3, the image 200 is not wholly satisfactory for OCR techniques. For example, the contrast between the characters and the background (the rest of the component) is often low, there may be blurring of the characters when they are printed on the component, and physical contact with the component may result in parts of characters being rubbed off. Thus, often, the character reading operation 201 produces an erroneous result, so that the comparison operation 203 says that the component is not the correct one.

Therefore, the present invention seeks to make use of the fact that there will be many identical components on the board, and where the components are identical, they will have come from a common reel. Thus, either all those components are correct, or all those components are incorrect because the wrong reel was placed in the placement machine 15. Therefore, this knowledge can be used to determine whether components are, in fact, the correct ones or not by considering the comparison operation over several identical components. If a sufficiently large number of them are determined to be correct (or a sufficiently small number of them are determined to be incorrect), then it can be inferred that all are correct.

Thus, in this embodiment, when N supposedly identical components are inspected, using the process illustrated in Fig. 3, if m of them are determined to be correct, then it can be determined that all the N supposedly identical components are correct. Moreover if N is part of a set of Q components, all identical, then the determination established that all Q are correct.

Determining N and m is a complex process because there is no wholly correct answer. The higher the value of m/N, then the higher the accuracy of the determination. On the other hand, the greater the likelihood is of the components being determined as incorrect. Moreover, the higher the value of N, the greater the accuracy of the measurement (because more components are taken into consideration) but the time for reaching such determination will increase. Thus, in practice, both N and m will be determined on the basis of a particular component being investigated, and may vary from component to component. For example, if N is 4 and m is 3, then the process of Fig. 3 will determine that all the identical components (which may be greater than N) are correct if the components are investigated and only one does not pass the comparison operation 203.

In the further development of this, this determination of N and m may be multistage. Thus, if N components are investigated and at least m are determined to be correct, then it can be decided that all identical components are correct. However, if N components are investigated and less than m are determined to be incorrect then, rather than saying all the components are incorrect, further components may be investigated, increasing N and m. Hence, in a second stage, if N and m are changed to n' and m' being 10 and 7 respectively, then if four components are inspected and two fail, a further six components may be investigated (so now N' have been investigated) and provided there is only one further failure, so m' is determined to be correct, then it may be to determine that all identical components are correct.

Normally, N will be less than the total number of identical components of a particular type so that not all those components need to be investigated. Thus, the inspection process may be speeded up as compared with arrangements in which all components are looked at. Of course, this depends on the number of identical components for a particular type on the PCB.

It would be possible to apply the techniques discussed above in the second inspection unit 16, rather than third inspection unit 19. However, because it is common to inspect the correctness of the soldering using the optical system of Fig. 2, the present invention may be applied at the third inspection unit 19 without requiring further structural arrangements.

In order to compare the characters read from a component with the correct characters for the component, it is necessary to know which component should be at a particular location, and which characters should be present on the component in that location. The location may come from information originating during the design of the circuit board, or may come from data from placement machine 15, since that placement machine will be programmed to take a particular component (which is identified by the programming of the placement machine) and put it in a particular location. The same will be true for all components on the PCB. Yet another way of obtaining the information would be to derive it from measurements taken from reference PCBs, although that would usually not be preferred because of inaccuracies in the reading of characters from such reference PCBs. In principle, therefore, a memory 138 may store, for each component, the X and Y co-ordinates for the component, the height of the component, the number of the reel from which it was obtained, the circuit reference and the characters on the component.

The above discussion has assumed that there are a plurality of identical components of a particular type on each circuit board, and the present invention investigates at least some of them, to determine whether they are all correct or not. It would also be possible to apply the invention over a plurality of circuit boards, to investigate a plurality of identical components distributed over those boards, but it can be known that all those components were mounted by the placement machine 15 from a common reel or other source. In that case, the present invention could check a predetermined number being only some of the plurality of boards, to see if the components were the correct ones, and if the proportion of components checked which were correct were sufficiently high, then it could be assumed that all those components, on all the plurality boards, were correct. In order for this work successfully, there may need to be linking between the placement machine 15 and the appropriate unit inspection unit 16 or 19, to ensure that the inspection unit 16, 19 was re-triggered when a reel was changed within the placement machine 15, so that it could not longer be assumed that the components previously checked were correct on subsequent boards where the components came from a different reel.

## Claims

1. A method of manufacturing one or more circuit boards, including inspection of a predetermined number of identical components on said one or more circuit boards, comprising the steps of:
a) mounting a first predetermined number of identical components on said one or more circuit boards;
b) investigating a second predetermined number of said identical components on said one or more circuit boards, said investigation including reading characters on said second predetermined number of said identical components using an optical character reader;
c) for each of said second predetermined number of said identical components, comparing said characters with a stored set of characteristics;
d) determining if at least a third predetermined number of said second predetermined number of said plurality of identical components are such that the characters read therefrom correspond to said stored set of characters, said third predetermined number being less than the second predetermined number.
e) determining that said one or more circuit boards have been manufactured correctly in respect of all said first predetermined number of identical components if the determination at step (d) is achieved.

2. A method according to claim 1, wherein said third predetermined number is 50% of said second predetermined number.

3. A method of manufacturing one or more circuit boards, including inspection of a predetermined number of identical components on said one or more circuit boards, comprising the steps of:
a) mounting a first predetermined number of identical components on said one or more circuit boards;
b) investigating a second predetermined number of said identical components on said one or more circuit boards, said investigation including reading characters on said second predetermined number of said identical components using an optical character reader;
c) for each of said second predetermined number of said identical components comparing said characters with a stored set of characteristics;
d) determining if no more than a fourth predetermined number said fourth predetermined number being of said second predetermined number of said identical components are such that the characters read therefrom do not correspond to said stored set of characters, said fourth predetermined number being less than the first predetermined number; and
e) determining that said one or more circuit boards have been manufactured correctly in respect of all said first predetermined number of identical components if the determination at step (d) is achieved.

4. A method according to any one of the preceding claims, wherein said second predetermined number is less than said first predetermined number.

5. A method according to any one of the preceding claims further including applying solder material to said one or more circuit boards, causing said solder material to reflow to cause said plurality of components to adhere said one or more circuit boards, wherein said step (b) is carried out after said reflow of said solder material.

6. A method according to any one of claims 1 to 4, further including applying solder material to said one or more circuit boards, causing said solder material to reflow to cause said plurality of components to adhere said one or more circuit boards, wherein said step (b) is carried out prior to said reflow of said solder material.

7. An apparatus for manufacturing one or more circuit boards including inspection of a predetermine number of identical components on said one or more circuit boards, comprising:
a mounting assembly for mounting a first predetermined number of identical components on said one or more circuit boards;
a reading device investigating a second predetermined number of said identical components on said one or more circuit boards, said investigation including reading characters on said second predetermined number of identical components using an optical character reader;
an analyser for analysing said characters, and the analyser being arranged to:
a) for each of said second predetermined number of said plurality of identical components, comparing said characters with a stored set of characteristics;
b) determining if at least a third predetermined number of said second predetermined number of said plurality of identical components are such that the characters read therefrom correspond to said stored set of characters, said third predetermined number being less than the second predetermined number.
c) determining that said one or more circuit boards have been manufactured correctly in respect of all said first predetermined number of identical components if the determination at step (b) is achieved.

8. An apparatus for manufacturing one or more circuit boards, comprising:
a mounting assembly for mounting a first predetermined number of identical components on said one or more circuit boards;
a reading device for investigating a second predetermined number of said identical components on said one or more circuit boards, said investigation including reading characters on said second predetermined number of identical components using an optical character reader; and an analyser for analysing said characters, the analyser being arranged:
a) for each of said second predetermined number of said plurality of identical components comparing said characters with a stored set of characteristics;
b) determining if no more than a fourth predetermined number of said second predetermined number of said identical components are such that the characters read therefrom do not correspond to said stored set of characters, said fourth predetermined number being less than the first predetermined number; and
c) determining that said one or more circuit boards have been manufactured correctly in respect of all said first predetermined number of identical components if the determination at step (b) is achieved.

9. An apparatus according to claim 7 or claim 8, further including means for applying solder material to said one or more circuit boards, an oven for causing said solder material to reflow to cause said plurality components to adhere to said one or more circuit boards, and a transportation device for transporting said one or more circuit boards from said oven to said reading device.

10. An apparatus according to claim 7 or claim 8, further including means for applying solder material to said one or more circuit boards, an oven for causing said solder material to reflow to cause said plurality components to adhere to said one or more circuit boards, and a transportation device for transporting said one or more circuit boards from said reading device to said oven.
